# EUROPEAN PATENT SPECIFICATION

(11) **EP 2 485 481 B1**
(45) Date of publication and mention of the grant of the patent: **15.03.2017**
(21) Application number: 12152200.7
(22) Date of filing: 24.01.2012
(51) Int. Cl.: H04N 5/52, H03G 3/30

(54) **Broadcast receiving device and broadcast receiving method**
Rundfunkempfangsvorrichtung und Rundfunkempfangsverfahren
Dispositif de réception de diffusion et procédé de réception de diffusion

(30) Priority: 28.01.2011 JP 2011016035
(43) Date of publication of application: 08.08.2012
(73) Proprietor: Panasonic Corporation, Kadoma-shi Osaka 571-8501 (JP)
(72) Inventor: Uemura, Toshiaki, Osaka-shi, Osaka, 540-6207 (JP); Takeuchi, Akio, Osaka-shi, Osaka, 540-6207 (JP); Ozeki, Hiroaki, Osaka-shi, Osaka, 540-6207 (JP)
(74) Representative: Pautex Schneider, Nicole Véronique

(56) References cited:
- EP-A2- 2 237 415
- JP-A- 2004 153 718
- "ETSI EN 302 755, V1. 1. 1 - Digital Video Broadcasting (DVB); Frame structure channel coding and modulation for a second generation digital terrestrial television broadcasting system (DVB-T2)", 2009, EUROPEAN TELECOMMUNICATIONS STANDARDS INSTITUTE, XP002677473, page 89, * page 89 *

## Description

### BACKGROUND OF THE INVENTION

### 1. Field of the Invention

The present invention relates to a broadcast receiving device and a broadcast receiving method. More specifically, the present invention relates to a broadcast receiving device and a broadcast receiving method capable of preventing a malfunction even when data in a specific band of a broadcast signal to be received is missing.

### 2. Description of the Related Art

In recent years, digitization of a broadcast signal is being progressed. In general, a broadcast signal carried by a carrier wave is added with many identifiers to identify a kind and a content of the broadcast signal. A broadcast receiving device that receives a broadcast signal is also performed with various controls corresponding to identifiers. These controls are described in a document ETSI EN 302 755, V1. 1. 1, 2009, pp. 19, by European Telecommunications Standards Institute, for example.

As an example of an identifier contained in a broadcast signal, there is a flag that indicates whether data in a specific area is present in the broadcast signal. A broadcast receiving device can decide whether to control a device to prepare for the data in the specific area, by deciding a content of the flag.

In the document ETSI EN 302 755, there are described Future Extension Frames (hereinafter, abbreviated as "FEF") in a DVB-T2 broadcast system. According to a standard of the DVB-T2 system of a digital television broadcast, it is assumed that a broadcasting station builds unique data and information concerning a broadcast signal into the FEF and that the broadcasting station uses the data and the information for entirely a different usage. That is, the FEF is a mechanism that includes various data as a future expansion. The receiving device can decide presence or absence of the FEF, by referring to this specific information. This specific information is a flag, for example. In the document ETSI EN 302 755, it is assumed that the flag is described in transmission data of the DVB-T2 broadcast system.

However, even when the flag indicates that data in a specific area is present in a broadcast signal, there is an exceptional situation that the data in the specific area is not present in the broadcast signal. In this case, because the flag indicates that data in a specific area is present in the broadcast signal, a conventional broadcast receiving device disadvantageously performs a process by deciding that data is present in the specific area, although the data in the specific area is not actually present.

An operation of the conventional broadcast receiving device is explained by taking this device which is based on the DVB-T2 broadcast system, as an example. When data is not present at an FEF portion in a broadcast signal of the DVB-T2 broadcast system, there is a risk of occurrence of inconvenience in an operation of an AGC (Automatic Gain Controller) that performs an output signal adjustment. This is because a signal detecting unit of the AGC detects that there is no signal due to the missing of a signal in the FEF portion in the signal band. In this case, the operation of the AGC becomes rapid. As a result, a gain from an input of the broadcast receiving device to the signal detecting device of the AGC becomes rapidly large. When the operation of the AGC becomes rapid and also when the gain from the input of the conventional broadcast receiving device to the signal detecting unit of the AGC becomes large, there is a possibility of occurrence of a case where a signal is not correctly output before the AGC is stabilized, when a frame of a signal of a next DVB-T2 broadcast system of the FEF portion has arrived. Consequently, the conventional broadcast receiving device has a risk of generating inconvenience such as out of synchronization and block noise.

That is, the conventional broadcast receiving device has a problem of generating out of synchronization and block noise, when data is missing in a specific area of a broadcast signal to be received.

EP2237415 discloses a broadcasting signal receiving apparatus and a control method thereof. The broadcasting signal receiving apparatus comprises a signal receiver which receives a broadcasting signal comprising at least one future extension frame; a signal sensor which senses a level of the received broadcasting signal; an automatic gain controller which performs automatic gain control to make the broadcasting signal have a certain level according to the sensed level of the broadcasting signal; and a control signal generator which generates a control signal to apply the automatic gain control to the broadcasting signal according to whether the broadcasting signal is in the future extension frame. With this, the AGC is performed according to whether it is the future extension frame or not, thereby preventing the signal from distortion, real-time controlling the AGC to be performed or frozen, and improving adjacent channel interference rate characteristics.

### SUMMARY OF THE INVENTION

The present invention relates to a broadcast receiving device according to claim 1.

According to the broadcast receiving device of the present invention, it becomes possible to perform a suitable control by reading a flag in a broadcast signal. As a result, a DVB-T2 signal that includes an FEF signal can be received without inconvenience, by suitably controlling an AGC, for example.

The present invention also relates to a broadcast receiving method according to claim 3.

### BRIEF DESCRIPTION OF THE DRAWINGS

FIG. 1 is a block diagram showing an outline function of a broadcast receiving device according to an embodiment of the present invention.
FIG. 2 is a detailed block diagram of a frontend unit and a decoder that the broadcast receiving device has according to the embodiment of the present invention.
FIG. 3 is an operation flowchart of the broadcast receiving device according to the embodiment of the present invention.
FIG. 4 is an operation flowchart of a broadcast receiving device according to another example of the embodiment of the present invention.
FIG. 5 is a diagram showing a configuration of a bit stream that is obtained by demodulating a signal received by the broadcast receiving device.
FIG. 6 is an operation explanatory diagram of an AGC according to the embodiment of the present invention.
FIG. 7 is a detailed block diagram of a frontend unit and a decoder that a broadcast receiving device according to another example of the embodiment of the present invention has.
FIG. 8 is an operation explanatory diagram of an AGC according to another example of the embodiment of the present invention.

### DETAILED DESCRIPTION OF PREFERRED EMBODIMENT EXEMPLARY EMBODIMENT

A preferred embodiment of the present invention is explained below with reference to accompanying drawings.

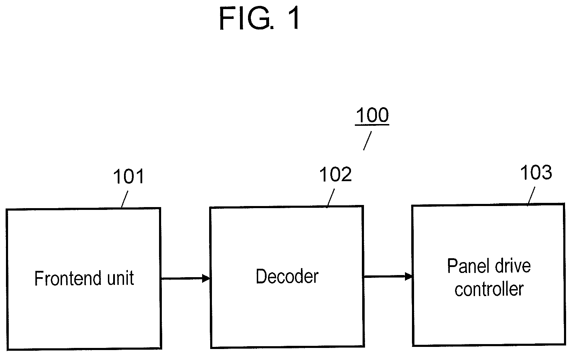

FIG. 1 is a block diagram showing an outline function of broadcast receiving device 100 according to the present embodiment of the present invention. Broadcast receiving device 100 is a device that is used to watch a broadcast or a content distributed by a broadcast or by communications. Broadcast receiving device 100 has frontend unit 101, decoder 102, and panel drive controller 103.

Frontend unit 101 demodulates an RF signal (radio frequency signal) as a broadcast signal received by an antenna (not shown) into a digital signal.

Decoder 102 demodulates a digital signal demodulated by frontend unit 101 into a video signal.

Panel drive controller 103 converts a video signal demodulated by decoder 102 into a format in which the video signal can be displayed by a display device such as a plasma display panel (not shown). Then, panel drive controller 103 outputs a converted video signal to a display device (not shown) that is connected separately.

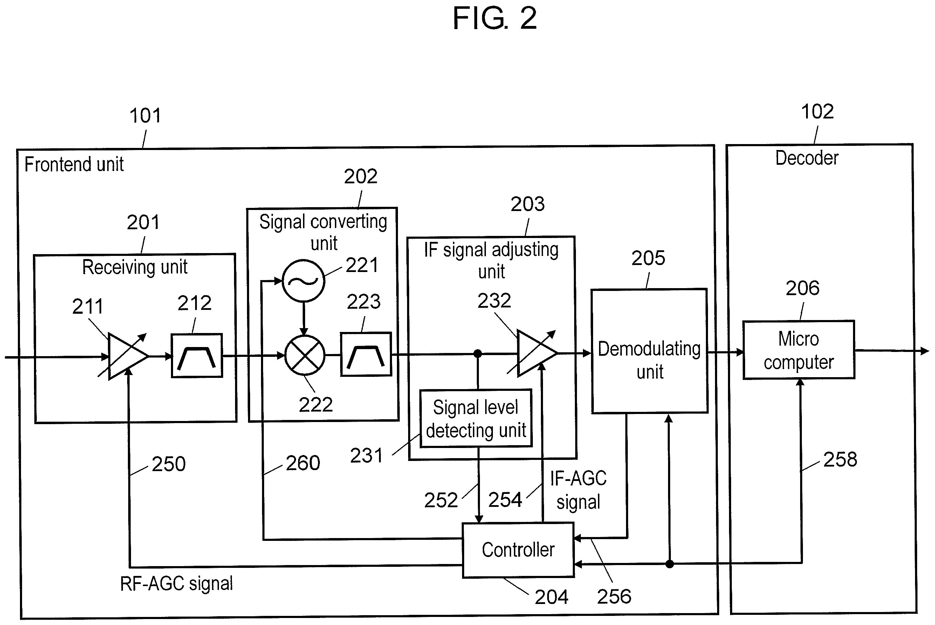

Next a configuration of frontend unit 101 and decoder 102 are explained in detail with reference to FIG. 2.

FIG. 2 is a detailed block diagram of frontend unit 101 and decoder 102 that broadcast receiving device 100 has, according to the present embodiment. FIG. 2 is a block diagram exemplifying a configuration method of only main constituent elements according to the present embodiment. Other constituent elements can be also included, and a configuration can be provided by using equivalent constituent elements.

First a configuration of frontend unit 101 is explained. Frontend unit 101 has receiving unit 201, signal converting unit 202, IF signal adjusting unit 203, controller 204, and demodulating unit (DVB-T2 demodulator) 205.

Receiving unit 201 receives an RF signal as a broadcast signal. Receiving unit 201 has RF amplifier 211, and filter 212. RF amplifier 211 adjusts an output level of a received RF signal, based on RF-AGC (Radio Frequency Automatic Gain Control) signal 250 as a control signal from controller 204 described later. Filter 212 extracts only a desired band from a received RF signal.

Signal converting unit 202 converts an RF signal of which an output level adjusted by receiving unit 201, into an IF signal (intermediate frequency signal). Signal converting unit 202 has local oscillating circuit 221, mixer 222, and filter 223. Local oscillating circuit 221 oscillates a predetermined frequency, based on signal 260 from controller 204. Mixer 222 frequency-converts a received RF signal into an IF signal, by using a signal generated by local oscillating circuit 221. Filter 223 extracts only a desired band from a frequency-converted IF signal.

IF signal adjusting unit 203 adjusts an output level of an IF signal that is output from signal converting unit 202. IF signal adjusting unit 203 has signal level detecting unit 231 and IF amplifier 232. Signal level detecting unit 231 detects a level of a received IF signal. A level of a detected IF signal is notified to controller 204 as IF level detection signal 252. IF amplifier 232 adjusts an output level of an input IF signal, based on IF-AGC (Intermediate Frequency Automatic Gain Control) signal 254 as a control signal from controller 204.

Controller 204 controls receiving unit 201, IF signal adjusting unit 203, etc. based on instructions from demodulating unit 205 described later and micro computer 206 described later. Controller 204 has an input/output terminal of control signal 258 for an I₂C (INTER-Integrated Circuit) that is known as a general-purpose control interface, and input/output terminals of analog voltage signals. Controller 204 outputs control instructions to RF-AGC and IF-AGC. A signal of RF-AGC signal 250 by controller 204 adjusts an output level to RF amplifier 211, based on a level of an IF signal that is obtained by signal level detecting unit 231 and an instruction of micro computer 206 described later.

Demodulating unit 205 demodulates an IF signal output from IF amplifier 232, and outputs a demodulated digital signal from a modulated broadcast signal. That is, in the present embodiment, demodulating unit 205 has a function that can demodulate a digital signal modulated according to a DVB-T2 standard as an already-known broadcast standard. Further, demodulating unit 205 detects a level of an IF signal when a broadcast signal is demodulated, and outputs analog signal 256 to controller 204, to keep this level at a proper level upon demodulating this level. Demodulating unit 205 further outputs a bit error rate when demodulating a bit stream, to controller 204 and micro computer 206 by using control signal 258 by the I₂C.

Decoder 102 has micro computer 206. Decoder 102 generates by micro computer 206 a digital signal decoded from a digital signal demodulated. Micro computer 206 includes an arithmetic logic unit, a RAM (Random Access Memory), a ROM (Read Only Memory), and the like, and sequentially executes software stored in the ROM. Micro computer 206 decodes a demodulated digital signal according to a predetermined procedure described in software, and decodes into a video signal and an audio signal. Decoder 102 has various constituent elements to decode a digital signal into a video signal, in addition to micro computer 206.

Further, micro computer 206 analyzes a reception state, and generates an instruction to control operations of other constituent parts. Further, micro computer 206 analyzes a content of a digital signal decoded by decoder 102. An instruction generated by micro computer 206 is transmitted to each constituent part via controller 204. Constituent parts that micro computer 206 controls by using the I₂C include receiving unit 201, signal converting unit 202, IF signal adjusting unit 203, and demodulating unit 205.

These constituent elements can be configured by mutually independent circuit elements, or can be configured as an integrated circuit such as a silicon IC.

An operation of the broadcast receiving device according to the embodiment of the present invention is explained next.

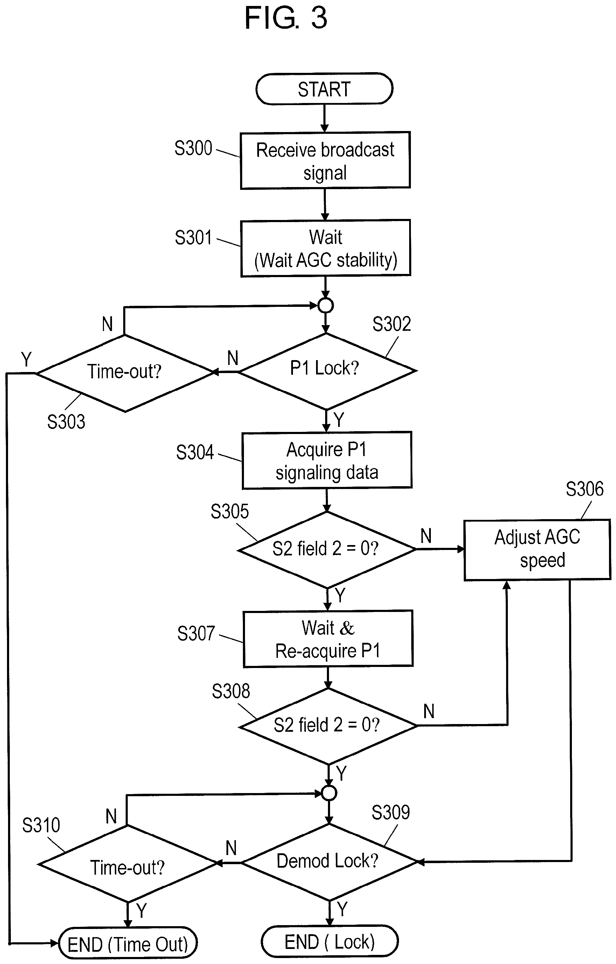

FIG. 3 is an operation flowchart of broadcast receiving device 100 according to the present embodiment. In the present embodiment, an operation of broadcast receiving device 100 is explained for a case where a broadcast signal that is broadcasted based on the DVB-T2 standard is received.

First, to receive a broadcast signal, broadcast receiving device 100 selects a channel of a broadcast signal of a desired frequency band, and receives the broadcast signal (Step S300). Specifically, first, a user selects a desired channel with a remote controller (not shown) or the like. Then, micro computer 206 sets a frequency to be received, according to an instruction from the remote controller. A frequency to be received is determined by the user of the broadcast receiving device, or micro computer 206 autonomously determines a frequency by a control signal contained in the broadcast signal or by a control signal input from a modem (not shown) as an interface with an external device. Then, the frequency to be received is notified from micro computer 206 to local oscillating circuit 221, by control signal 260 by the I₂C, via controller 204. Local oscillating circuit 221 generates an oscillation signal according to a frequency to be received. Then an RF signal of a desired frequency band is converted into an IF signal by mixer 222. A converted IF signal is input to demodulating unit 205 via IF signal adjusting unit 203.

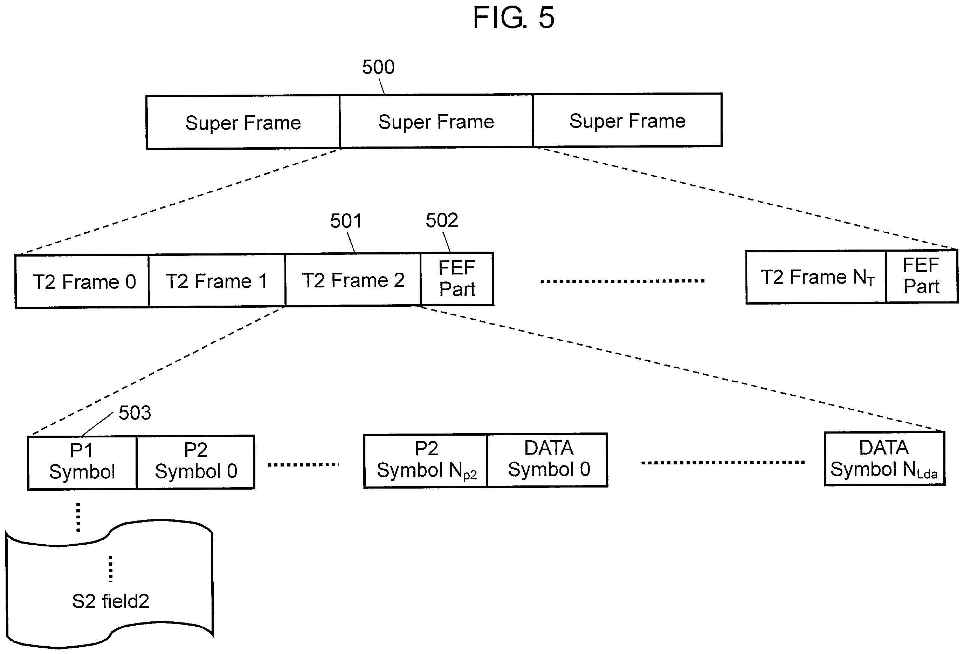

Before explaining a detailed operation of demodulating unit 205, a configuration of a signal that broadcast receiving device 100 receives is explained. FIG. 5 is a diagram showing a configuration of a bit stream that is obtained by demodulating a signal received by broadcast receiving device 100 in the present embodiment. In the DVB-T2 standard, an OFDM modulation system, which is as one of digital modulation systems, is employed. As shown in FIG. 5, in the DVB-T2 standard, a bit stream is configured by a plurality of Super Frames 500. That is, Super Frame 500 is a partition unit of the bit stream. A plurality of T2 Frames 501 is present in Super Frame 500. In Super Frame 500, FEF 502 is present in some cases (In FIG. 5, FEF is described as "FEF Part", by referring to a document ETSI EN 302 755).

FEF 502 is a frame in which accommodation of various data is scheduled as a future expansion, as described above. Therefore, a receiving device that matches the DVB-T2 standard has a specification in which FEF 502 is not demodulated.

A plurality of symbols is included in T2 Frame 501. These symbols are modulation units of OFDM modulation. Further, P1 symbol 503 that stores information such as a transmission parameter is present in T2 Frame 501. Further, P1 symbol 503 contains S2 information that indicates whether Super Frame 500 to which P1 symbol 503 belongs contains the FEF. That is, S2 information is specific information contained in a broadcast signal. The specific information is information that indicates presence or absence of data in FEF 502 as a specific area of a bit stream obtained by demodulating a broadcast signal. FIG. 5 shows that S2 information is contained in "S2 field 2". Demodulating unit 205 suitably analyzes such a packet structure and a syntax, and performs a demodulation operation.

Referring back to FIG. 3, a detailed operation of demodulating unit 205 is explained. Broadcast receiving device 100 performs a wait operation in Step S301. That is, demodulating unit 205 performs the wait operation until a control operation of the AGC that controller 204 performs becomes stable. With this arrangement, demodulation unit 205 waits for a stabilization of an IF signal that is input to demodulating unit 205.

In a P1 Lock confirmation in Step S302, micro computer 206 analyzes a signal demodulated by demodulating unit 205, and confirms whether P1 symbol 503 contained in the broadcast signal according to the DVB-T2 standard has been able to be synchronously received. When P1 Lock cannot be confirmed ("N" in Step S302), the process proceeds to Step S303. On the other hand, when P1 Lock has been able to be confirmed ("Y" in Step S302), the process proceeds to Step S304.

Next, in a Time-out confirmation in Step S303, broadcast receiving device 100 confirms whether P1 symbols 503 can be synchronously received during a set time. When P1 symbols 503 cannot be synchronously received during a set time ("Y" in Step S303), broadcast receiving device 100 decides that a broadcast signal cannot be received, and stops a reception operation. On the other hand, when a set time is not reached ("N" in Step S303), the process returns to Step S302, and broadcast receiving device 100 repeats a series of operations.

In P1 signaling data acquisition in Step S304, micro computer 206 acquires S2 information from P1 symbol 503. The S2 information is specific information contained in a broadcast signal, and is information concerning a broadcast parameter. The S2 information contains information concerning whether Super Frame 500 to which the S2 information belongs contains FEF 502, for example.

Next, in Step S305, micro computer 206 refers to the S2 information. Micro computer 206 confirms whether data of S2 field2 as an identifier is 0 (that is, FEF is not present). S2 field2 indicates whether Super Frame 500 to which the S2 information belongs contains FEF 502.

When FEF 502 is present ("N" in Step S305), the process proceeds to Step S306. In AGC speed adjustment in Step S306, micro computer 206 sets the tracking speed of the AGC to be slower than a normal tracking speed. Specifically, in RF-AGC, micro computer 206 controls RF amplifier 211 via controller 204, and sets the tracking speed of RF-AGC to be slower than a normal tracking speed. In IF-AGC, micro computer 206 controls IF amplifier 232 via controller 204, and sets the tracking speed of IF-AGC to be slower than a normal tracking speed. The process proceeds to Step S309.

As described above, broadcast receiving device 100 according to the present embodiment has receiving unit 201 that receives a broadcast signal, RF amplifier 211 and IF amplifier 232 as an amplifier that amplify the broadcast signal to a certain level by tracking the received broadcast signal with a predetermined tracking speed, and controller 204 that controls the predetermined tracking speed of the amplifier based on specific information contained in the broadcast signal. Controller 204 controls the predetermined tracking speed of the amplifier to be slower than a normal tracking speed when the specific information contains information that indicates presence of the data in the specific area.

A method of setting an AGC tracking speed is different depending on a configuration of a device. Whether to set the tracking speeds of both RF-AGC and IF-AGC to slow speeds or to set the tracking speed of only one of RF-AGC and IF-AGC to a slow speed can be suitably changed by a gain partitioning of RF amplifier 211 and IF amplifier 232. When a gain partitioning is deviated large to RF amplifier 211, micro computer 206 sets the tracking speed of RF-AGC to a slow speed, because a signal amplified by RF amplifier 211 has a large influence. When a gain partitioning is deviated large to IF amplifier 232, micro computer 206 sets the tracking speed of IF-AGC to a slow speed, because the signal amplified by IF amplifier 232 has a large influence. When there is no deviation in the gain partitioning of RF amplifier 211 and IF amplifier 232, micro computer 206 can set the tracking speeds of both RF-AGC and IF-AGC to slow speeds.

In wait in Step S307, micro computer 206 performs wait during only a maximum period that FEF 502 can occupy. Further, thereafter, micro computer 206 acquires P1 signaling data again. Significance of performing wait during only a maximum period that FEF 502 can occupy is explained here. A maximum period that FEF 502 can occupy is 250 msec, for example.

P1 symbol 503 is also contained in FEF 502. S2 field2 that FEF 502 itself has cannot be trusted. This is because a way of using FEF 502 is free and there is no guarantee that data of S2 field2 is normal. Then, even when micro computer 206 decides that data of S2 field2 is 0 (the FEF is not present), there is a risk that FEF 502 is present in Super Frame 500. That is, there is a risk that data is not normal even when P1 Signaling data in Step S304 has been acquired and that a wrong decision is made that an FEF signal is not present despite a fact that an FEF signal is present.

Accordingly, provision of wait for a maximum time of FEF 502 (Step S307) can avoid a risk of reading an FEF 502 part again and can securely ensure a value of field2 by acquiring P1 signaling data again. This method of preventing an erroneous decision can be a method of deciding data of S2 field, by first reading P1 signaling data, waiting for a maximum time of FEF 502, and then reading P1 signaling data again.

Next, a signal condition deciding unit in Step S308 confirms whether data of S2 field2 as an identifier that identifies whether FEF 502 is present in an S2 signal is 0 (there is no FEF), in a similar manner to that in Step S305. When FEF 502 is not present ("Y" in Step S308), the process proceeds to Step S309. On the other hand, when FEF 502 is present ("N" in Step S308), the process proceeds to Step S306.

In a demodulation synchronization confirmation (Demod Lock) in Step S309, micro computer 206 confirms whether a signal other than a P1 signal is synchronous, and decides whether a broadcast signal according to the DVB-T2 standard can be received. When a signal other than the P1 signal is synchronous ("Y" in Step S309), micro computer 206 regards that demodulation is synchronous. On the other hand, when a signal other than the P1 signal is not synchronous ("N" in Step S309), the process proceeds to Step S310.

In Time-out decision in Step S310, when demodulation is not synchronized during a set time ("Y" in Step S310), micro computer 206 decides that a broadcast signal can not be received, and stops a reception operation. On the other hand, when a set time is not reached ("N" in Step S310), the process returns to Step S309, and broadcast receiving device 100 repeats the series of operations.

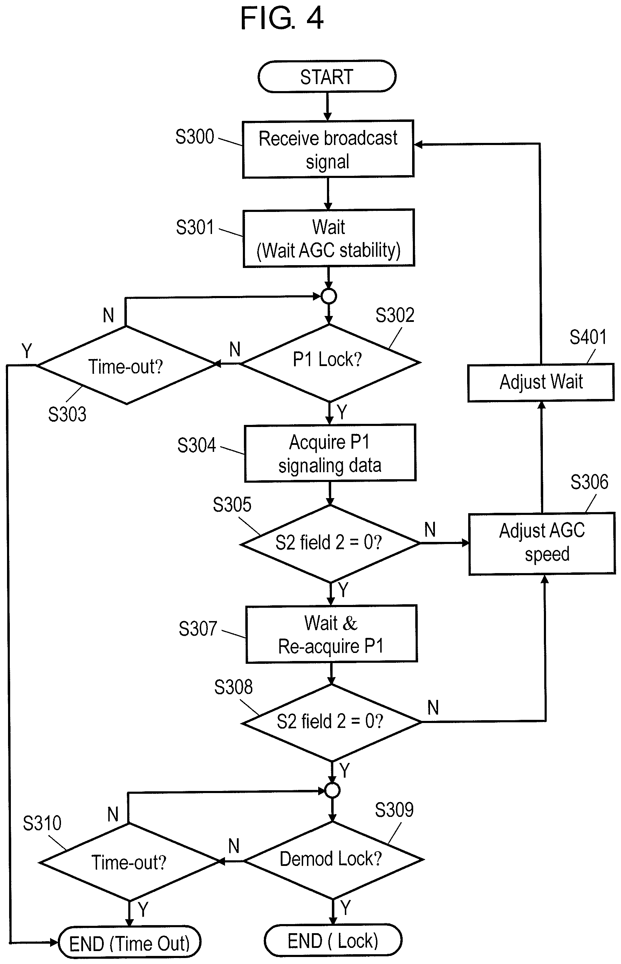

There is a case where a device is configured such that a change of a tracking speed of the AGC is not immediately reflected and that the tracking speed of the AGC is reflected for the first time after a channel is selected again. In this case, it is suggested that control is performed as shown in FIG. 4 as another example of the present embodiment.

FIG. 4 is an operation flowchart of broadcast receiving device 100 according to another example of the present embodiment. The another example of the present embodiment is different from the embodiment explained above in that, after an AGC speed is adjusted in Step S306, a control flow is directed to Step S300, and a channel is selected again.

Step S401 that is added to between Step S306 and Step S300 is explained. Wait adjustment in Step S401 is to change the time of wait at S301 corresponding to a speed of the tracking speed of the AGC, because the tracking speed of the AGC has been set to be slower than a normal tracking speed at S306. In this way, the change of the tracking speed of the AGC can be made valid.

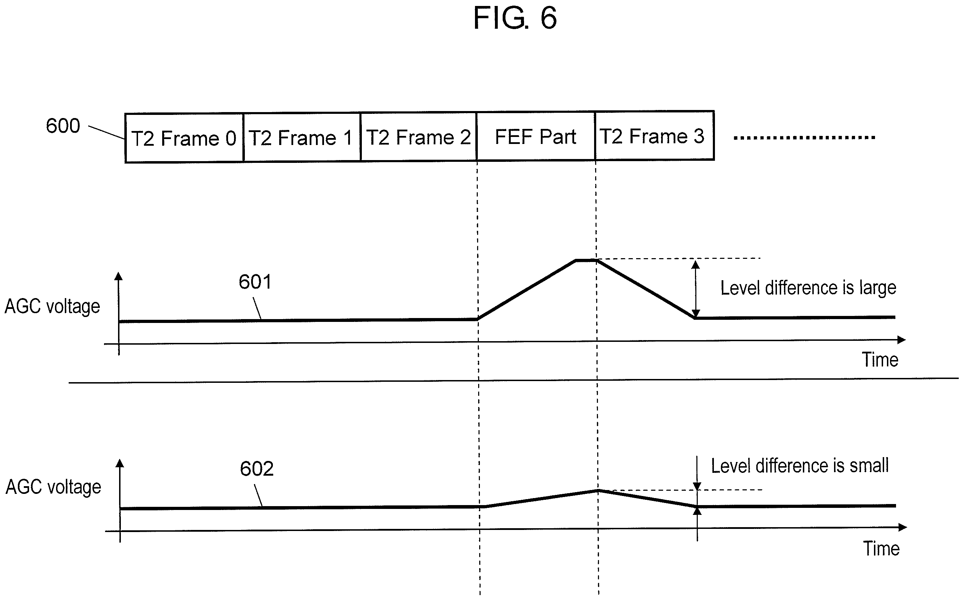

Next, an operation effect of setting the tracking speed of the AGC to be slower than a normal tracking speed is explained with reference to FIG. 6. FIG. 6 is an operation explanatory diagram of the AGC according to the embodiment of the present invention.

When the tracking speed of the AGC is set to be slower than a normal tracking speed, this becomes useful when data of S2 field2 is 1 (the FEF is present) and also when data is not actually present in FEF 502. A reason for this is explained below.

Frame 600 according to the DVB-T2 standard shown in FIG. 6 is a frame that demodulating unit 205 processes. Waveform 601 shows a behavior of an AGC voltage when the tracking speed of the AGC is not set to a slow speed. When the tracking speed of the AGC is set to be slower than a normal tracking speed, waveform 602 shows a behavior of an AGC voltage. Waveforms 601 and 602 of the AGC voltage can be either RF-AGC or IF-AGC described above. These waveforms can be considered as waveforms of a virtual AGC voltage obtained by converting the RF signal into the IF signal and by integrating RF-AGC and IF-AGC that are used to set a level of the IF signal constant.

An example of the tracking speed of the AGC is described below. At a normal tracking speed of the AGC, when the input level of the broadcast signal changes by 40 dB, for example, the AGC adjusts the IF signal to a constant level within around 100 ms. The IF signal that is adjusted to a constant level is input to demodulator 205. When the tracking speed of the AGC is set to be slower than a normal tracking speed, and when the input level of the broadcast signal changes by 12 dB, for example, the AGC adjusts the IF signal to a constant level within around 100 ms.

First, as an assumption, the tracking speed of the AGC has a deep relationship with a channel selection speed. In general, the tracking speed of the AGC is set fast. That is, when the tracking speed of the AGC is not set to be slower than a normal tracking speed, that is, when there is no control of the present invention, an AGC voltage takes a behavior of waveform 601, when the data of S2 field2 is 1 (the FEF is present) and also when data is not actually present in FEF 502. This is because when a signal in FEF 502 is attempted to be demodulated, a signal is not present at a position where FEF 502 should be present, and micro computer 206 decides that a weak signal is being received, and attempts to rapidly amplify the IF signal large by RF-AGC or IF-AGC.

When the AGC voltage takes a behavior of waveform 601, the AGC rapidly operates during a period of receiving FEF 502, and a value of the AGC exceeds a proper value at a restart time of T2 Frame after FEF 502. That is, a level difference during the FEF period of waveform 601 is large. Therefore, a bit error occurs at a demodulation time. As a result, block noise occurs. Even when a bit error occurs at a demodulation time, and when the bit error is within a range not generating block noise in decoder 102, it is permissible that a bit error rate of decoder 102 at a demodulation time of the bit stream does not substantially exceed zero. This is because decoder 102 has a capacity of concealing a bit error and not generating block noise, when a bit error rate is substantially near zero.

On the other hand, when the control of the present invention is used, even when FEF is present as shown by waveform 602, the tracking speed of the AGC can be set to be slower than a normal tracking speed. That is, when data of S2 field2 is 1 (the FEF is present) and also even when data is not actually present in FEF 502, it is controlled such that the AGC does not substantially track during a period of FEF 502. As a result, a level difference during the FEF period of waveform 602 is small. Therefore, a signal can be received without inconvenience even at a restart time of the T2 Frame after FEF 502.

That is, controller 204 of broadcast receiving device 100 according to the present embodiment controls a predetermined tracking speed of the amplifier to slow down to a range in which a bit error rate at a demodulation time of the bit stream does not substantially exceed zero within a period of a specific area.

Although presence or absence of the FEF is set as a condition of the tracking speed of the AGC in the above explanation, control can be performed in more detail by adding a length or a cycle of the FEF to the condition.

When an FEF signal is present at the time of receiving a broadcast signal according to the DVB-T2 standard as described above, by setting the tracking speed of the AGC to be slower than a normal tracking speed, it becomes possible to suppress the tracking speed of the AGC signal to a missing signal even when the signal in a band is missing when the FEF signal does not contain data, and it becomes possible to avoid a possibility of generating block noise without an immediate return of a waveform value of the AGC to a proper value, at a restart time of data of a next broadcast signal according to the DVB-T2 standard. In the case of other than the FEF signal, the tracking speed of the AGC is not changed. Therefore, a phenomenon that a channel selection operation becomes slow when a normal broadcast is watched does not occur.

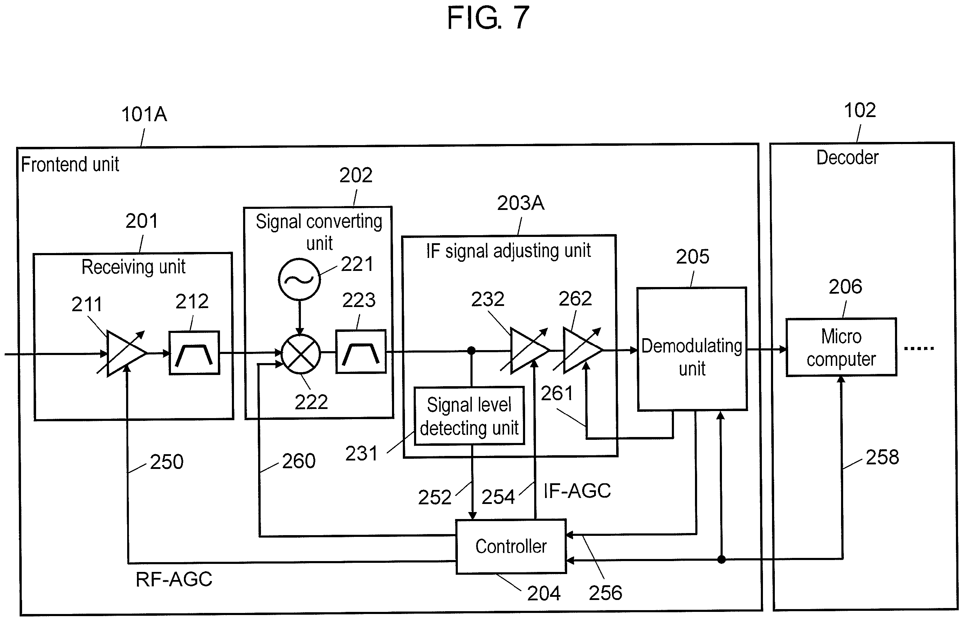

Another broadcast receiving device according to the embodiment of the present invention is explained next. FIG. 7 is a detailed block diagram of frontend unit 101A and decoder 102 that a broadcast receiving device according to another example of the embodiment of the present invention has. As shown in FIG. 7, IF signal adjusting unit 203A of frontend unit 101A further has IF amplifier 262. IF amplifier 262 inputs a signal from IF amplifier 232, and outputs this signal to demodulating unit 205. In this case, IF amplifier 262 adjusts an output level of an output signal, based on IF-AGC signal 261 as a control signal from demodulating unit 205. According to this configuration, as the number of constituent elements of a loop of the AGC that uses IF amplifier 262 is small, a delay time concerning the constituent elements can be made small. Therefore, a response of the AGC can be made in high precision. As a result, demodulating unit 205 can input an IF signal in higher precision.

In the present embodiment, it is explained that a tracking speed of an AGC voltage to a missing signal can be suppressed by setting a predetermined tracking speed of the amplifier to be slower than a normal tracking speed. In this way, even when a signal in a band of an RF signal in a broadcast signal is missing when data is not present in an FEF signal, a possibility of generation of block noise can be avoided. However, tracking of the AGC voltage can be limited to a predetermined range, instead of suppressing the tracking speed of the AGC, as described below.

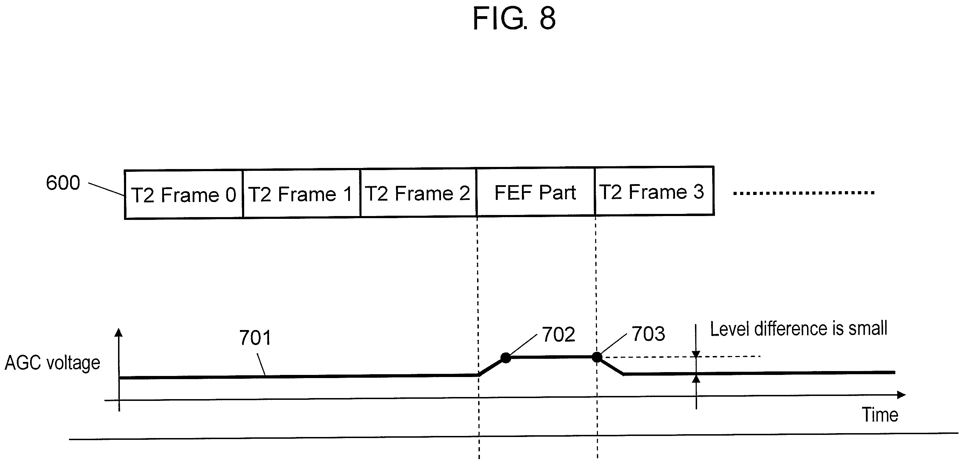

Tracking of the AGC in the above case is explained with reference to FIG. 8. FIG. 8 shows frame 600 that demodulating unit 205 of the DVB-T2 standard processes, in a similar manner to that in FIG. 6. Waveform 701 shows a behavior of an AGC voltage. Assume that data of S2 field2 is 1 (the FEF is present) and that data is not actually present in FEF 502. Also, assume that a bit error rate at a demodulation time of the bit stream is substantially zero. Demodulating unit 205 is always detecting a bit error rate, and can output a value of a detected bit error rate via control signal 258 by the I₂C.

In this situation, the tracking speed of the AGC is set to fast. Therefore, the AGC voltage starts changing even when a waveform has an inclination equivalent to that of waveform 601 in FIG. 6.

Next, controller 204 inputs a bit error rate from demodulating unit 205, and decides whether the bit error rate has substantially exceeded zero. When the bit error rate has substantially exceeded zero (point 702 of waveform 701 in FIG. 8), controller 204 sets the AGC voltage such that a bit error rate immediately before does not substantially exceed zero. Then, controller 204 controls a predetermined tracking speed of the amplifier to fix to zero, at an upper limit within a range in which the bit error rate does not substantially exceed zero. Then, controller 204 waits for an end of the FEF (point 703 of waveform 701 in FIG. 8). After point 703, the AGC responds at a normal tracking speed.

That is, when a bit error rate at a demodulation time of the bit stream substantially exceeds zero, within a period (FEF) of a specific area, controller 204 controls a predetermined tracking speed of the amplifier to be fixed to zero, at an upper limit within a range in which the bit error rate does not substantially exceed zero.

With this arrangement, a function similar to that in the present embodiment can be achieved. That is, by limiting the tracking of the AGC voltage to within a predetermined range, it becomes possible to avoid a possibility of the occurrence of block noise without an immediate return of a waveform value of the AGC to a proper value at a restart time of data of a next broadcast signal of the DVB-2 standard.

## Claims

1. A broadcast receiving device comprising:
a receiving unit (201) configured to receive a broadcast signal of the DVB-T2 standard;
an amplifier (211, 232) configured to amplify the broadcast signal to a certain level by tracking the received broadcast signal with a predetermined tracking speed; and
a controller (204) configured to control the predetermined tracking speed of the amplifier based on specific information contained in the broadcast signal,
wherein
the specific information (S2) contained in the broadcast signal is information that indicates presence or absence of data in a specific area of a bit stream obtained by demodulating the broadcast signal, the specific area being a Future Extension Frame (502) part, and
**characterized in that** the controller is configured to control the predetermined tracking speed of the amplifier to track slower when the specific information contains information that indicates presence of the data in the specific area.

2. The broadcast receiving device according to claim 1, further including a demodulating unit 205 for demodulating a bit stream and for outputting a bit error rate when demodulating a bit stream to the controller 204;
wherein the controller (204) is configured to control the predetermined tracking speed of the amplifier to slow down to a range in which a bit error rate at a demodulation time of the bit stream does not exceed a bit error rate that is within a range not generating block noise in a decoder (102) within a period of the specific area.

3. A broadcast receiving method comprising:
receiving a broadcast signal of the DVB-T2 standard;
amplifying the broadcast signal to a certain level by an amplifier by tracking the received broadcast signal with a predetermined tracking speed; and
controlling the predetermined tracking speed of the amplifier based on specific information contained in the broadcast signal;
wherein the specific information contained in the broadcast signal is information that indicates presence or absence of data in a specific area of a bit stream obtained by demodulating the broadcast signal, the specific area being a Future Extension Frame (502) part, and
**characterized in that** the predetermined tracking speed of the amplifier is controlled to track slower when the specific information contains information that indicates presence of the data in the specific area.

4. The broadcast receiving method according to claim 3, wherein the predetermined tracking speed of the amplifier is controlled to slow down to a range in which a bit error rate at a demodulation time of the bit stream does not exceed a bit error rate that is within a range not generating block noise in a decoder (102) within a period of the specific area.

## Patentansprüche

1. Rundfunkempfangsvorrichtung, aufweisend:
eine Empfangseinheit (201), konfiguriert zum Empfangen eines Rundfunksignals nach der DVB-T2-Norm;
einen Verstärker (211, 232), konfiguriert zum Verstärken des Rundfunksignals auf einen bestimmten Pegel durch Verfolgen des empfangenen Rundfunksignals mit einer im Voraus festgelegten Verfolgungsgeschwindigkeit; und
einen Regler (204), konfiguriert zum Regeln der im Voraus festgelegten Verfolgungsgeschwindigkeit des Verstärkers auf Basis von spezifischer Information, die im Rundfunksignal enthalten ist,
wobei
die spezifische Information (S2), die im Rundfunksignal enthalten ist, Information ist, die ein Vorhandensein oder eine Abwesenheit von Daten in einem spezifischen Bereich eines durch Demodulieren des Rundfunksignals erhaltenen Bitstroms angibt, wobei der spezifische Bereich ein Teil eines Future Extension Frame (502) ist, und
**dadurch gekennzeichnet, dass** der Regler zum Regeln der im Voraus festgelegten Verfolgungsgeschwindigkeit des Verstärkers konfiguriert ist, um langsamer zu verfolgen, wenn die spezifische Information Information enthält, die ein Vorhandensein der Daten in dem spezifischen Bereich angibt.

2. Rundfunkempfangsvorrichtung nach Anspruch 1,
ferner aufweisend eine Demodulationseinheit 205 zum Demodulieren eines Bitstroms und zum Ausgeben einer Bitfehlerrate bei Demodulieren eines Bitstroms an den Regler 204;
wobei der Regler (204) zum Regeln der im Voraus festgelegten Verfolgungsgeschwindigkeit des Verstärkers konfiguriert ist zum Verlangsamen herunter auf einen Bereich, in dem eine Bitfehlerrate bei einer Demodulationszeit des Bitstroms eine Bitfehlerrate nicht überschreitet, die innerhalb eines Bereichs liegt, der innerhalb einer Periode des spezifizierten Bereichs kein Blockrauschen in einem Dekodierer (102) erzeugt.

3. Rundfunkempfangsverfahren, aufweisend:
Empfangen eines Rundfunksignals nach der DVB-T2-Norm;
Verstärken des Rundfunksignals auf einen bestimmten Pegel durch Verfolgen des empfangenen Rundfunksignals mit einer im Voraus festgelegten Verfolgungsgeschwindigkeit; und
Regeln der im Voraus festgelegten Verfolgungsgeschwindigkeit des Verstärkers auf Basis von spezifischer Information, die im Rundfunksignal enthalten ist;
wobei die spezifische Information, die im Rundfunksignal enthalten ist, Information ist, die ein Vorhandensein oder eine Abwesenheit von Daten in einem spezifischen Bereich eines durch Demodulieren des Rundfunksignals erhaltenen Bitstroms angibt, wobei der spezifische Bereich ein Teil eines Future Extension Frame (502) ist, und
**dadurch gekennzeichnet, dass** die im Voraus festgelegte Verfolgungsgeschwindigkeit des Verstärkers geregelt ist, um langsamer zu verfolgen, wenn die spezifische Information Information enthält, die ein Vorhandensein der Daten in dem spezifischen Bereich angibt.

4. Rundfunkempfangsverfahren nach Anspruch 3, wobei die im Voraus festgelegte Verfolgungsgeschwindigkeit des Verstärkers geregelt ist zum Verlangsamen herunter auf einen Bereich, in dem eine Bitfehlerrate bei einer Demodulationszeit des Bitstroms eine Bitfehlerrate nicht überschreitet, die innerhalb eines Bereichs liegt, der innerhalb einer Periode des spezifizierten Bereichs kein Blockrauschen in einem Dekodierer (102) erzeugt.

## Revendications

1. Dispositif de réception de diffusion comprenant :
une unité de réception (201) configurée pour recevoir un signal de diffusion de la norme DVB-T2 ;
un amplificateur (211, 232) configuré pour amplifier le signal de diffusion à un certain niveau en suivant le signal de diffusion reçu avec une vitesse de poursuite prédéterminée ; et
un contrôleur (204) configuré pour contrôler la vitesse de poursuite prédéterminée de l'amplificateur sur la base d'informations spécifiques contenues dans le signal de diffusion,
dans lequel
les informations spécifiques (S2) contenues dans le signal de diffusion sont des informations qui indiquent la présence ou l'absence de données dans une zone spécifique d'un flux binaire obtenu en démodulant le signal de diffusion, la zone spécifique étant une partie de Trame d'Extension Future (502), et
**caractérisé en ce que** le contrôleur est configuré pour contrôler la vitesse de poursuite prédéterminée de l'amplificateur pour suivre plus lentement lorsque les informations spécifiques contiennent des informations qui indiquent la présence des données dans la zone spécifique.

2. Dispositif de réception de diffusion selon la revendication 1, comprenant en outre une unité de démodulation 205 pour démoduler un flux binaire et pour sortir un taux d'erreur binaire lors de la démodulation d'un flux binaire vers le contrôleur 204;
dans lequel le contrôleur (204) est configuré pour contrôler la vitesse de poursuite prédéterminée de l'amplificateur pour ralentir à une plage dans laquelle un taux d'erreur binaire à un temps de démodulation du flux binaire ne dépasse pas un taux d'erreur binaire qui est à l'intérieur d'une plage ne générant pas de bruit de bloc dans un décodeur (102) à l'intérieur d'une période de la zone spécifique.

3. Procédé de réception de diffusion comprenant :
la réception d'un signal de diffusion de la norme DVB-T2 ;
l'amplification du signal de diffusion à un certain niveau par un amplificateur en suivant le signal de diffusion reçu avec une vitesse de poursuite prédéterminée ; et
le contrôle de la vitesse de poursuite prédéterminée de l'amplificateur sur la base d'informations spécifiques contenues dans le signal de diffusion ;
dans lequel les informations spécifiques contenues dans le signal de diffusion sont des informations qui indiquent la présence ou l'absence de données dans une zone spécifique d'un flux binaire obtenu en démodulant le signal de diffusion, la zone spécifique étant une partie de Trame d'Extension Future (502), et
**caractérisé en ce que** la vitesse de poursuite prédéterminée de l'amplificateur est contrôlée pour suivre plus lentement lorsque les informations spécifiques contiennent des informations qui indiquent la présence des données dans la zone spécifique.

4. Procédé de réception de diffusion selon la revendication 3, dans lequel la vitesse de poursuite prédéterminée de l'amplificateur est contrôlée pour ralentir à une plage dans laquelle un taux d'erreur binaire à un temps de démodulation du flux binaire ne dépasse pas un taux d'erreur binaire qui est à l'intérieur d'une plage ne générant pas de bruit de bloc dans un décodeur (102) à l'intérieur d'une période de la zone spécifique.
